# EUROPEAN PATENT APPLICATION

(11) **EP 2 317 559 A2**
(43) Date of publication of application: **04.05.2011**
(21) Application number: 10163993.8
(22) Date of filing: 27.05.2010
(51) Int. Cl.: H01L 31/0216, H01L 31/18

(54) **Solar cell and method of manufacturing the same**

(30) Priority: 30.10.2009 KR 20090104649
(71) Applicant: SAMSUNG ELECTRONICS CO., LTD., Suwon-si, Gyeonggi-do (KR)
(72) Inventor: Lee, Jung-Hyun, Gyeonggi-do (KR); Lee, Chang-Soo, Gyeonggi-do (KR); Ma, Dong-Joon, Gyeonggi-do (KR)
(74) Representative: Grünecker, Kinkeldey, Stockmair & Schwanhäusser Anwaltssozietät

(57) **Abstract**

A solar cell including: a semiconductor substrate including a p-type layer and an n-type layer; a dielectric layer disposed on the semiconductor substrate and including a silicate represented by the following Chemical Formula 1

Chemical Formula 1 x M₂O₃ · y SiO₂

wherein M is a Group 13 element and x and y are real numbers wherein 0<2x<y and x+y=1; a first electrode in electrical communication with the p-type layer of the semiconductor substrate; and a second electrode in electrical communication with the n-type layer of the semiconductor substrate.

## Description

### BACKGROUND

### 1. Field

This disclosure relates to a solar cell and a method for manufacturing the same.

### 2. Description of the Related Art

A solar cell is a photoelectric conversion device that transforms solar energy into electrical energy. Solar cells have attracted much attention as a potential sustainable and pollution-free next generation energy source.

A solar cell includes p-type and n-type semiconductors and produces electrical energy by transferring electrons and holes to the n-type and p-type semiconductors, respectively, when an electron-hole pair ("EHP") is produced by light energy absorbed in a photoactive layer inside the semiconductors, and then collecting the electrons and holes in each of a positive and a negative electrode.

It is desirable for a solar cell to have as high an energy conversion efficiency as possible for producing electrical energy from solar energy. In order to increase the efficiency of a solar cell, it is desirable to improve the efficiency of generation of electron-hole pairs, and to efficiently withdraw the resulting charges with minimal loss.

The charges may be lost due to recombination of the produced electrons and holes.

### SUMMARY

An aspect of this disclosure provides a solar cell having improved efficiency due to reduction of charge loss, and a method of manufacturing the same.

According to an aspect of this disclosure, a solar cell includes a semiconductor substrate including a p-type layer and an n-type layer; a dielectric layer disposed on the semiconductor substrate and including a silicate represented by the following Chemical Formula 1:

Chemical Formula 1 x M₂O₃ · y SiO₂

wherein M is a Group 13 element and x and y are real numbers wherein 0<2x<y and x+y=1; a first electrode electrically connected to the p-type layer of the semiconductor substrate; and a second electrode electrically connected to the n-type layer of the semiconductor substrate.

The dielectric layer may have a thickness of about 1 nanometer (nm) to about 100 nm.

The solar cell may further include a protective layer disposed on a surface of the dielectric layer, wherein the protective layer has a refractive index which is lower than a refractive index of the dielectric layer. The protective layer may include silicon nitride, silicon oxide, aluminum oxide, or a combination including at least one of the foregoing. The protective layer may have a thickness of about 100 nm to about 700 nm.

The semiconductor substrate may further include a first side and an opposite second side, the dielectric layer may be disposed on the first side of semiconductor substrate, and the solar cell may further include an anti-reflection coating disposed on the second side of the semiconductor substrate.

According to another aspect of this disclosure, a method of manufacturing a solar cell includes: disposing a semiconductor substrate including a p-type layer and an n-type layer; disposing a dielectric layer including a silicate represented by the following Chemical Formula 1 on a side of the semiconductor substrate:

Chemical Formula 1 x M₂O₃ · y SiO₂

wherein M is a Group 13 element and x and y are real numbers wherein 0<2x<y and x+y=1; disposing a first electrode in electrical communication with the p-type layer of the semiconductor substrate; and disposing a second electrode in electrical communication with the n-type layer of the semiconductor substrate to form the solar cell.

The disposing of the dielectric layer may include disposing a silicon (Si) source, an M source, and an oxygen-containing gas.

The silicon source may include a compound including silicon, the compound including silicon having a moiety covalently bonded to the silicon, the moiety being hydrogen, a substituted or unsubstituted C1 to C30 alkyl group, a substituted or unsubstituted C3 to C30 cycloalkyl group, a substituted or unsubstituted C6 to C30 aromatic group, a substituted or unsubstituted C1 to C30 alkoxy group, a substituted or unsubstituted amide group, or a combination including at least one of the foregoing. The silicon source may include tetraethoxysilane (TEOS).

The M source may include a compound including a Group 13 element, the compound including the Group 13 element having a moiety covalently bonded to the Group 13 element, the moiety being hydrogen, a substituted or unsubstituted C1 to C30 alkyl group, a substituted or unsubstituted C3 to C30 cycloalkyl group, a substituted or unsubstituted C6 to C30 aromatic group, a substituted or unsubstituted C1 to C30 alkoxy group, a substituted or unsubstituted amide group, or a combination including at least one of the foregoing. The M source may include trimethylaluminum (TMA) and trimethylboron (TMB).

The oxygen-containing gas may include oxygen gas (O₂), ozone (O₃), or a combination including at least one of the foregoing.

The disposing of the dielectric layer may include atomic layer deposition (ALD) or plasma enhanced chemical vapor deposition (PECVD).

Other aspects of this disclosure will be further described in the following detailed description.

### BRIEF DESCRIPTION OF THE DRAWINGS

The above and other aspects, advantages and features of this disclosure will become more apparent by describing in further detail exemplary embodiments thereof with reference to the accompanying drawings, in which:
FIG. 1 is a cross-sectional view of an exemplary embodiment of a solar cell; and
FIGS. 2A to 2F are cross-sectional views showing an exemplary embodiment of a method of manufacturing a solar cell.

### DETAILED DESCRIPTION

Exemplary embodiments will hereinafter be described in further detail with reference to the accompanying drawings, in which various embodiments are shown. However, these embodiments are only exemplary, and this disclosure shall not be limited thereto. Rather, these embodiments are provided so that this disclosure will be thorough and complete, and will fully convey the scope of the invention to those skilled in the art.

As used herein, the term "and/or" includes any and all combinations of one or more of the associated listed items. It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present invention.

The terminology used herein is for the purpose of describing particular embodiments only and is not intended to be limiting. As used herein, the singular forms "a," "an," and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom," "upper" or "top," or "front" or "rear" may be used herein to describe one element's relationship to another elements as illustrated in the Figures. It will be understood that relative terms are intended to encompass different orientations of the device in addition to the orientation depicted in the Figures. For example, if the device in one of the figures is turned over, elements described as being on the "rear" side of other elements would then be oriented on "front" sides of the other elements. The exemplary term "rear," can therefore, encompasses both an orientation of "rear" and "front," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Unless otherwise defined, all terms (including technical and scientific terms) used herein have the same meaning as commonly understood by one of ordinary skill in the art to which this invention belongs.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

As used herein, unless otherwise provided, the term "substituted" refers to a compound or radical substituted with at least one (e.g., 1, 2, 3, 4, 5, 6, or more) substituents which may independently be a C1 to C30 alkyl group, a C2 to C30 alkenyl group, a C2 to C30 alkynyl group, a C6 to C30 aryl group, C7 to C30 arylalkyl group, a C1 to C30 alkoxy group, a C1 to C30 heteroalkyl group, a C3 to C30 heteroarylalkyl group, a C3 to C30 cycloalkyl group, a C3 to C30 cycloalkenyl group, a C5 to C30 cycloalkynyl group, a C2 to C30 heterocycloalkyl group, a C2 to C30 heterocycloalkenyl group, a C2 to C30 heterocycloalkynyl group, a halogen (e.g., F, Cl, Br, I, or a combination thereof), a hydroxy group, a nitro group, a cyano group, an amino group, an azido group, an amidino group, a hydrazino group, a hydrazono group, a carbonyl group, a carbamyl group, a thiol group, an ester group, a carboxyl group or a salt thereof, a sulfonic acid group or a salt thereof, a phosphoric acid group or a salt thereof, or a combination comprising at least one of the foregoing instead of hydrogen in a compound.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present therebetween. In contrast, when an element is referred to as being "directly on" another element, there are no intervening elements present. It will be also understood that when an element such as a layer, film, region, or substrate is referred to as being "under" another element, it may be directly under the other element or intervening elements may also be present.

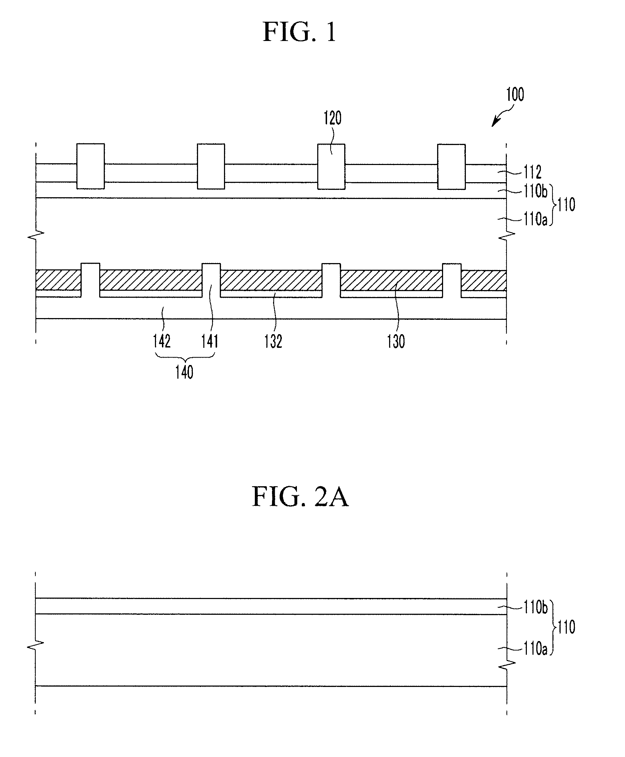

FIG. 1 is a cross-sectional view of an exemplary embodiment of a solar cell.

As used herein, a front side refers to a side of the solar cell which may be oriented towards the source of solar energy, and a rear side may refer to a side opposite the front side. Also, for better understanding and ease of description, the upper and lower positional relationships may be described relative to a center of the semiconductor substrate 110, but is not limited thereto.

A solar cell 100 according to an aspect includes the semiconductor substrate 110, which includes a lower semiconductor layer 110a and an upper semiconductor layer 110b.

The semiconductor substrate 110 may comprise crystalline silicon, a compound semiconductor, or a combination comprising at least one of the foregoing. The crystalline silicon may be, for example, a silicon wafer. One of the lower semiconductor layer 110a and the upper semiconductor layer 110b may be a semiconductor layer doped with a p-type impurity, and the other may be a semiconductor layer doped with an n-type impurity. The p-type impurity may be a Group 13 element such as boron (B), and the n-type impurity may be a Group 15 element such as phosphorus (P), wherein "Group" refers to a group of the periodic table of the elements according to the International Union of Pure and Applied Chemistry group classification system.

The surface of the semiconductor substrate 110 may be smooth or textured. A semiconductor substrate 110 having a textured surface may, for example, have protrusions and depressions, and the protrusions and depressions may have a spherical or rectilinear shape. In an embodiment, the protrusions may have a shape like a pyramid, or may be pores having a honeycomb shape. The semiconductor substrate 110 having a textured surface may have an enlarged surface area which may enhance a rate of light absorption and decrease reflectivity, thereby improving an efficiency of a solar cell.

An anti-reflection coating 112 may optionally be disposed on the front side of semiconductor substrate 110, thus although the anti-reflection coating 112 is shown, it may be omitted. The anti-reflection coating 112 may include an insulating material that substantially reduces or effectively eliminates reflection of light. For example, the anti-reflection coating may include an oxide, such as aluminum oxide (Al₂O₃), silicon oxide (SiO₂), titanium oxide (TiO₂ or TiO₄), magnesium oxide (MgO), cerium oxide (CeO₂), or a combination comprising at least one of the foregoing oxides; a nitride, such as aluminum nitride (AIN), silicon nitride (SiNₓ), or a combination comprising at least one of the foregoing nitrides; or an oxynitride such as aluminum oxynitride (AION), silicon oxynitride (SiON), titanium oxynitride (TiON), or a combination comprising at least one of the foregoing oxynitrides. The anti-reflection coating may comprise a single layer or may comprise multiple layers.

The anti-reflection coating 112 may be disposed on the front side of semiconductor substrate 110 to substantially reduce or effectively eliminate reflectance of incident light and the anti-reflection coating may further enhance selection of a certain wavelength region of the incident light. In addition, the anti-reflection coating may enhance the efficiency of the solar cell 100 by improving contact properties with silicon present on the surface of the semiconductor substrate 110.

A plurality of front electrodes 120 are disposed on the anti-reflection coating 112. The front electrodes 120 are arranged substantially in parallel to the substrate in a direction of the semiconductor substrate 110 and penetrate the anti-reflection coating 112, contacting the upper semiconductor layer 110b. The front electrodes 120 may be formed to penetrate the anti-reflection coating by firing. The front electrode 120 may comprise an electrically conductive material, such as silver (Ag), and may be have a grid pattern which minimizes shadowing loss and sheet resistance.

A front bus bar electrode (not shown) is optionally disposed on the front electrode 120. The front bus bar electrode connects adjace nt solar cells in a plurality of solar cells.

A dielectric layer 130 is disposed on the rear side of semiconductor substrate 110.

The dielectric layer 130 includes a silicate represented by the following Chemical Formula 1.

Chemical Formula 1 x M₂O₃ · y SiO₂

In the above Chemical Formula 1, M is a Group 13 element, and x and y are real numbers wherein 0<2x<y and x+y=1. In an embodiment, M comprises boron, aluminum, gallium, indium, thallium, or a combination comprising at least one of the foregoing. In another embodiment, M may be boron (B) or aluminum (Al).

When M is aluminum, the silicate represented by Chemical Formula 1 may have a structure represented by the following Chemical Formula 2.

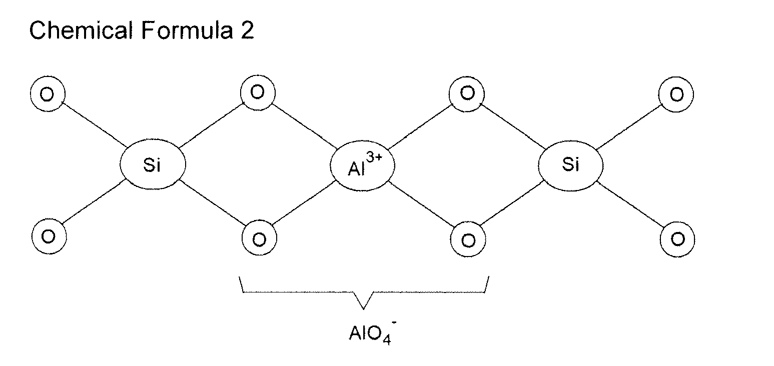

As is shown in Chemical Formula 2, the dielectric layer 130 may include an oxide comprising silicon and a Group 13 elem ent, and the dielectric layer 130 includes more silicon than the Group 13 element. Thus the trivalent positive ions of the Group 13 atoms receive electrons from oxygen and have a net negative charge. For example, when the Group 13 element is aluminum, a trivalent positive ion of aluminum (Al³⁺) is introduced into the silicon position of the structure in which a silicon atom would be connected and bound to four oxygen atoms. In the resulting structure, the trivalent positive ion of aluminum is thus bound with four oxygen atoms when it is in the silicon position. Thereby, the trivalent positive ions of aluminum receive more electrons from oxygen than their normal valence and thus the aluminum atoms have a net negative charge and can be represented as AlO₄⁻.

Because the silicate represented by Chemical Formula 1 has a net negative charge, it is possible to easily trap holes in the rear side of the semiconductor substrate 110 and substantially reduce or effectively prevent a minor carrier of electrons, which may be present in the lower semiconductor layer 110a, from transporting an electron to the rear side of the semiconductor substrate 110, where the electron could recombine with a hole. Thereby, it is possible to substantially reduce or effectively prevent the recombination and extinguishment of the electrons and holes in the rear side of the semiconductor substrate.

In addition, in an embodiment the silicate represented by Chemical Formula 1 is substantially or entirely amorphous and may maintain the amorphous state after being treated at a high temperature. Thus the silicate may not have a grain boundary, thereby reducing or entirely avoiding the loss of electrons which may be trapped in the grain boundary. The silicate represented by Chemical Formula I is a single-phase material.

Accordingly, the efficiency of a solar cell may be improved by reducing charge loss by recombination.

The dielectric layer 130 may have a thickness of about 1 nanometer (nm) to about 100 nm, specifically about 2 nm to about 90 nm, more specifically about 4 nm to about 80 nm. When the dielectric layer has a thickness within the foregoing range, it is possible to provide a desirable negative charge density and to effectively induce the electric field in the region adjacent to the semiconductor substrate. Thereby, the dielectric layer may easily trap holes and substantially reduce or effectively prevent electrons from transporting to the rear surface of the semiconductor. The dielectric layer 130 effectively improves the open circuit voltage (V_{oc}) and the life-span characteristics of the electrons and the holes, and may facilitate forming a desired bias. For example, the dielectric layer 130 may have a thickness of about 30 nm to about 80 nm, specifically 40 nm to about 70 nm, more specifically 50 nm to about 60 nm.

An optional protective layer 132 may be disposed on the lower side of the dielectric layer 130. Although the protective layer 132 is shown, it may be omitted.

The protective layer 132 may comprise a material having a refractive index which is lower than a refractive index of dielectric layer 130, and, for example, the protective layer may comprise silicon nitride (SiNₓ), silicon oxide (SiO₂), aluminum oxide (Al₂O₃), or a combination comprising at least one of the foregoing.

The protective layer 132 may substantially reduce or effectively prevent the loss of light and may enhance the efficiency of the solar cell by reflecting the light which has passed through the semiconductor substrate 110 back towards the semiconductor substrate 110 so that the light may be absorbed by the photoactive layer. In addition, the protective layer 132 may substantially reduce or effectively prevent the dielectric layer 130 and the semiconductor substrate 110 from being damaged during the manufacture of the rear electrode 140, which may include a high temperature baking process. However, when the dielectric layer 130 has sufficient thickness to reflect light and protect the semiconductor substrate 110, the protective layer 132 may be omitted.

In another embodiment, when the dielectric layer 130 is formed at a slower speed than a speed at which the protective layer 132 is formed, a dielectric layer 130 having a selected thickness may be formed on the semiconductor substrate 110 and then a thin film, which has a thickness suitable for the protective layer 132, may be further formed to provide the desired passivation characteristics, protect the semiconductor substrate, and to simultaneously shorten the duration of the manufacturing process.

The protective layer 132 may have a thickness of about 100 nm to about 700 nm, specifically about 200 nm to about 600 nm, more specifically about 300 nm to about 500 nm. When the protective layer 132 has a thickness within the foregoing range, it is possible to provide desirable passivation characteristics, sufficient protect the semiconductor substrate, sufficiently reduce or effectively eliminate light reflection, and effectively shorten the duration of the manufacturing process. For example, the protective layer 132 may have a thickness of about 150 nm to about 400 nm, about 160 nm to about 380 nm, more specifically about 180 nm to about 360 nm.

The dielectric layer 130 and the protective layer 132 may comprise a pattern, and the rear electrode 140 may contact the semiconductor substrate 110 through the pattern.

The rear electrode 140 is disposed on the dielectric layer 130, and on the protective layer 132 if present. In an embodiment, the rear electrode 140 is disposed on the lower side of the dielectric layer 130 and the protective layer 132. The rear electrode 140 may comprise an opaque metal such as aluminum (Al) and may have a thickness of about 1 micrometer (µm) to about 200 µm, specifically about 1 µm to about 100 µm, more specifically 5 µm to about 75 µm.

The rear electrode 140 may include a plurality of contact portions 141, which contact the lower semiconductor layer 110a through the space defined by the patterned dielectric layer 130 and the protective layer 132, and the rear electrode 140 may also include a connection portion 142, which is disposed on an entire or substantially an entire surface of the lower semiconductor layer 110a.

The contact portion 141 of the rear electrode 140 is a portion for forming a back surface field ("BSF"). When silicon is contacted with aluminum, aluminum functions as a p-type impurity, thus an internal electric field may be provided between the silicon and the aluminum. Thereby, it is possible to substantially reduce or effectively prevent electrons from being transported to the rear side. Therefore, it is possible to enhance the efficiency of the solar cell 100 by substantially reducing or effectively preventing the recombination and extinguishment of charges in the rear side of the semiconductor substrate 110.

In addition, the connection portion 142 of the rear electrode 140 reflects the light having passed through the se miconductor substrate 110 back towards the semiconductor substrate 110, thereby substantially reducing or effectively preventing loss of light. Thereby, it is possible to enhance the efficiency of the solar cell 100.

However, the rear electrode is not limited thereto, and the rear electrode 140 may be partially formed on the lower semiconductor layer 110a.

A rear bus bar electrode (not shown) is disposed on the lower side of the rear electrode 140. The rear bus bar electrode may connect adjacent solar cells when assembling a plurality of solar cells, and it may comprise a conducting material such as, for example, silver (Ag), aluminum (Al), or a combination comprising at least one of the foregoing.

Hereinafter, a method of manufacturing the solar cell according to an embodiment is described with reference to FIG. 2A to FIG. 2F together with FIG. 1.

FIGS. 2A to 2F are cross-sectional views sequentially showing an exemplary embodiment of a method of manufacturing a solar cell. In another embodiment, steps of the disclosed method may be performed in a different order.

First, a semiconductor substrate 110, such as a silicon wafer, is disposed. The semiconductor substrate 110 may be doped with, for example, a p-type impurity.

Subsequently, the semiconductor substrate 110 is subjected to a surface texturing process. The surface texturing may include, for example, a wet process using a strong acid solution, such as nitric acid, hydrofluoric acid, or a combination comprising at least one of the foregoing, or the wet process may use a strong base, such as potassium hydroxide, sodium hydroxide, or a combination comprising at least one of the foregoing, or the surface texturing may include a dry process, such as a process using a plasma, for example.

Referring to FIG. 2A, the semiconductor substrate 110 is doped with, for example, an n-type impurity. The n-type impurity may be doped by diffusing POCl₃, H₃PO₄, or the like, or a combination comprising at least one of the foregoing, and the diffusing may include treatment at a high temperature. Thereby, the semiconductor substrate 110 may include a lower semiconductor layer 110a and an upper semiconductor layer 110b, which are doped with different impurities from each other.

In another embodiment, a semiconductor substrate 110 doped with an n-type impurity may be subjected to a surface texturing process and then doped with a p-type impurity.

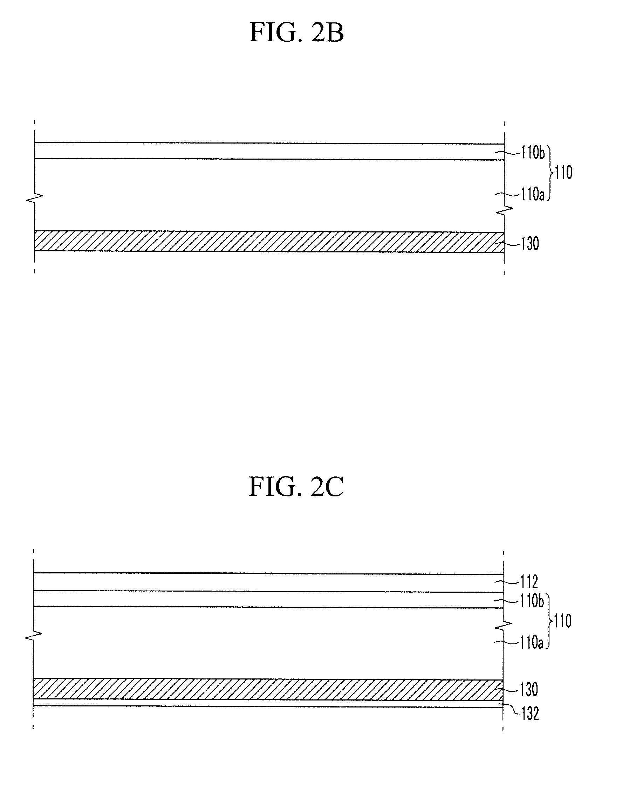

Referring to FIG. 2B, a dielectric layer 130, which includes a silicate represented by Chemical Formula 1, is formed (e.g., disposed) on the rear side of the semiconductor substrate 110.

The dielectric layer 130 may be formed by a chemical vapor deposition ("CVD") method, such as plasma enhanced chemical vapor deposition ("PECVD"), by atomic layer deposition ("ALD"), or the like, but is not limited thereto.

The method of forming the dielectric layer 130 will be further described hereafter.

As shown in FIG. 2C, a protective layer 132 is formed (e.g., disposed) on the lower side of dielectric layer 130, and an anti-reflection coating 112 is optionally formed (e.g., disposed) on the front surface of the semiconductor substrate 110. The protective layer 132 and the anti-reflection coating 112 may be formed by, for example, PECVD and may comprise silicon nitride. However, neither the protective layer 132 nor the anti-reflection coating 112 are limited thereto, and the protective layer 132 and the anti-reflection coating 112 may comprise another material or be formed by another method. The protective layer 132 and the anti-reflection coating 112 may be formed (e.g., disposed) simultaneously; or the protective layer 132 may be formed (e.g., disposed) before forming (e.g., disposing) the anti-reflection coating 112. In another embodiment, the anti-reflection coating 112 may be formed (e.g., disposed) before forming (e.g., disposing) the protective layer 132.

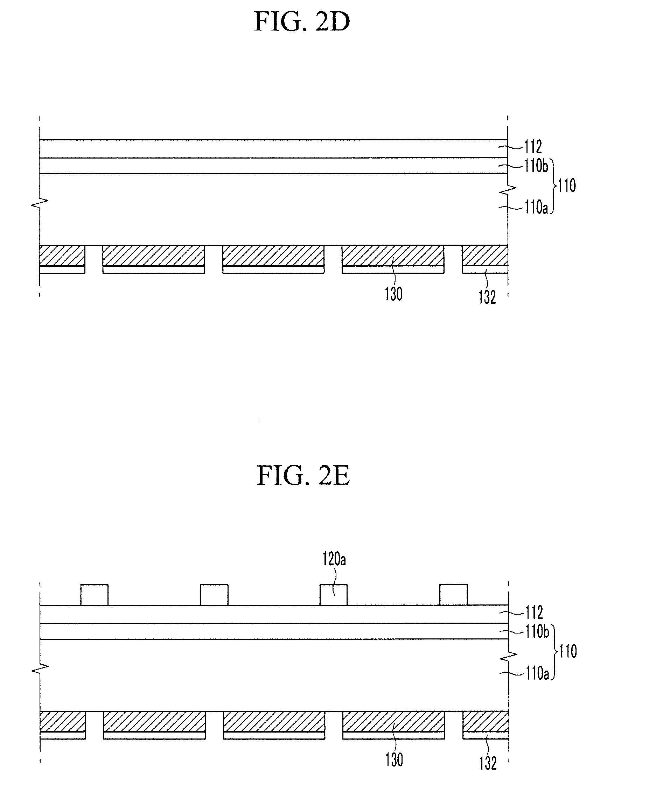

Referring to FIG. 2D, the dielectric layer 130 and protective layer 132 are patterned. The patterning may include, for example, a lower contact opening process using a laser or an etching process using an etching paste.

Then, referring to FIG. 2E, a conductive paste 120a for a front electrode is disposed on the anti-reflection coating 112. The conductive paste 120a for a front electrode may be disposed by screen printing. The screen printing may include coating the conductive paste 120a for the front electrode on a location where the electrode is to be formed, and drying the same. The conductive paste 120a may include a metal powder such as silver (Ag), or the like. However, the method of forming the front electrode is not limited thereto, and the front electrode may be formed (e.g., disposed) by inkjet printing or press printing.

Then the conductive paste 120a for a front electrode is dried. The drying may be performed at a temperature of, for example, about 150°C to about 400°C, specifically 200°C to about 350°C, more specifically about 250°C to about 300°C.

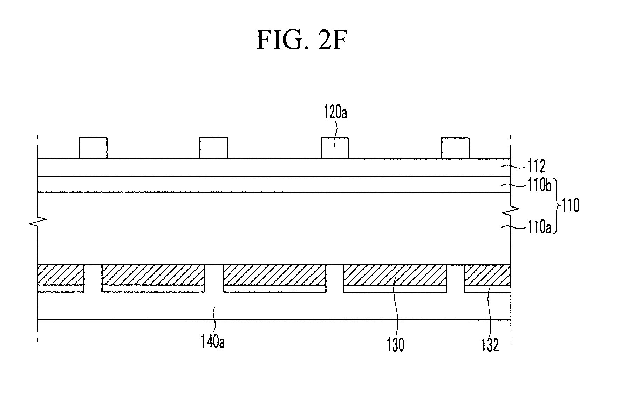

Referring to FIG. 2F, a conductive paste 140a for a rear electrode is disposed on the lower side of the dielectric layer 130 and the protective layer 132. The conductive paste 140a for a rear electrode is first disposed on the exposed portion of the semiconductor substrate, which may be exposed by patterning the dielectric layer 130 and the protective layer 132, and the conductive paste 140a is then disposed on a portion of or an entirety of the lower surface of the dielectric layer 130 and the protective layer 132. However, the disposing of the conductive paste 140a is not limited thereto, and the conductive paste 140a for a rear electrode may be simultaneously disposed on the portion where the dielectric layer 130 and the protective layer 132 are patterned and the entire lower surface of the dielectric layer 130 and the protective layer 132.

The conductive paste 140a for a rear electrode may be disposed by screen printing. The screen printing may include coating the conductive paste 140a for a rear electrode and drying the conductive paste 140a. The conductive paste 140a may include a metal powder, such as aluminum (Al). The forming of the rear electrode is not limited thereto, and the rear electrode may be formed (e.g., disposed) by inkjet printing or press printing. Then the conductive paste 140a for a rear electrode is dried. The drying may be performed at a temperature of, for example, about 150°C to about 400°C, specifically 200°C to about 350°C, more specifically about 250°C to about 300°C.

As shown in FIG. 1, the conductive paste 120a for a front electrode and the conductive paste 140a for a rear electrode may result in a front electrode 120 and a rear electrode 140, respectively, and the metal powder may permeate or be infused into the upper semiconductor layer 110b and the lower semiconductor layer 110a, respectively, during the baking process. The baking may be performed at a higher temperature than the fusion temperature of the metal powder, for example, at a temperature of about 600°C to about 1000°C, specifically about 650°C to about 950°C, more specifically about 700°C to about 900°C.

Then a front bus bar electrode (not shown) may be disposed on the front electrode 120, and a rear bus bar electrode (not shown) may be disposed on the rear electrode 140.

Hereinafter, the method of providing the dielectric layer 130 is further described.

The semiconductor substrate 110 is introduced into a CVD chamber and a silicon source, an M source, and an oxygen-containing gas are simultaneously or sequentially supplied to the semiconductor substrate 110 as component sources for the silicate represented by Chemical Formula 1.

When the silicon source, the M source, and the oxygen-containing gas are simultaneously supplied, these sources and the oxygen-containing gas are excited by a plasma, contacted in a chamber, and a reaction product thereof deposited on the semiconductor substrate to provide a dielectric layer 130, wherein the reaction product includes the silicate represented by Chemical Formula 1.

When the silicon source, the M source, and the oxygen-containing gas are sequentially supplied, for example, the silicon source may be first supplied, deposited, and purged with the inert gas, then the M source may be supplied, deposited, and purged with the inert gas, and then the oxygen-containing gas may be supplied, excited by plasma, and contacted with the silicon source and the M source in a chamber to provide a dielectric layer 130 including the silicate represented by Chemical Formula 1.

The composition of the resulting silicate and the thickness of the dielectric layer may be controlled by selecting values for certain process factors, such as an amount of each source, a concentration of each source, an amount of oxygen-containing gas, a concentration of oxygen-containing gas, a depositing duration, a deposition number, or the like.

The chemical vapor deposition ("CVD") may be performed at a temperature of about 100°C to about 500°C, specifically at a temperature of about 200°C to about 400°C, more specifically at 250°C to about 350°C.

The silicon source is not particularly limited as long as it is deposited as a thin film. For example, the silicon source may include a compound including silicon and a moiety bound to the silicon. In an embodiment, the moiety bound to the silicon is hydrogen, a substituted or unsubstituted C1 to C30 alkyl group, a substituted or unsubstituted C3 to C30 cycloalkyl group, a substituted or unsubstituted C6 to C30 aromatic group, a substituted or unsubstituted C1 to C30 alkoxy group, a substituted or unsubstituted amide group, or a combination comprising at least one of the foregoing. For example, the silicon oxide source may include tetraethoxysilane ("TEOS"). In an embodiment, the silicon oxide source is TEOS.

The M source is not particularly limited as long as it can be deposited as a thin film, and for example, the M source may include a compound including an M atom and a moiety bound to the M atom. In an embodiment the moiety bound to the M atom is hydrogen, a substituted or unsubstituted C1 to C30 alkyl group, a substituted or unsubstituted C3 to C30 cycloalkyl group, a substituted or unsubstituted C6 to C30 aromatic group, a substituted or unsubstituted C1 to C30 alkoxy group, a substituted or unsubstituted amide group, or a combination comprising at least one of the foregoing. When M is aluminum, the M source may include, for example, trimethylaluminum ("TMA"), and when M is boron, the M source may include, for example, trimethylboron ("TMB"). In an embodiment, the M source is TMA, TMB, or a combination of TMA and TMB.

The oxygen-containing gas may include oxygen gas (O₂), ozone (O₃), or a combination comprising at least one of the foregoing, and the oxygen-containing gas may exist in an excited state upon excitation by a plasma in a chamber. When the oxygen-containing gas is excited, the precursors to the silicate represented by Chemical Formula 1, such as the silicon source and the M source, are easily oxidized and upon contact with each other they easily and effectively provide a dielectric layer including the silicate represented by Chemical Formula 1.

However, foregoing method is not limited thereto, and the dielectric layer 130 may be formed by atomic layer deposition. In another embodiment, the semiconductor substrate 110 is introduced into an atomic layer deposition chamber, a silicon source is supplied to the chamber and deposited, the chamber is purged with the inert gas, an M source material is supplied to the chamber and deposited, the chamber is purged with the inert gas, the chamber is then supplied with an oxygen-containing gas, and the oxygen-containing gas is excited with a plasma in the chamber an d contacted with the silicon source and the M source to provide a dielectric layer 130 which includes a silicate represented by Chemical Formula 1.

The composition of the resulting silicate and the thickness of the dielectric layer may be controlled by selecting values of process factors such as a concentration of each source, a concentration of oxygen-containing gas, a depositing duration, a deposition number, or the like.

In addition, the atomic layer deposition may be performed at a temperature of about 100°C to about 500°C, or for example, specifically at a temperature of about 200°C to about 300°C, more specifically at about 250°C.

The resulting dielectric layer includes a silicate represented by Chemical Formula 1, and the silicate represented by Chemical Formula 1 is substantially or entirely amorphous and may maintain the amorphous state even after treatment at a high temperature. If the dielectric layer were to be crystallized, a grain boundary would result, and a charge would be trapped in the grain boundary, thus the amount of charge that could be transported would be decreased. However, because the disclosed dielectric layer is amorphous and not crystallized by heat treatment, even at a high temperature, the disclosed dielectric layer does not form a grain boundary, thereby substantially reducing or effectively preventing charge loss.

According to an embodiment, it is possible to provide a high negative charge density and to reduce the recombination of charges in the rear side of semiconductor substrate by providing a dielectric layer which includes the silicate represented by Chemical Formula 1 on the rear side of the semiconductor substrate. Accordingly, it is possible to reduce the charge loss and enhance the efficiency of the solar cell.

While this disclosure has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A solar cell (100) comprising:
a semiconductor substrate (110) including a p-type layer (110a, 110b) and an n-type layer (110b, 110a);
a dielectric layer (130) disposed on the semiconductor substrate and including a silicate represented by the following Chemical Formula 1:
Chemical Formula 1 x M₂O₃ · y SiO₂
wherein M is a Group 13 element and x and y are real numbers wherein 0<2x<y and x+y=1;
a first electrode (140, 120) in electrical communication with the p-type layer of the semiconductor substrate; and
a second electrode (120, 140) in electrical communication with the n-type layer of the semiconductor substrate.

2. The solar cell of claim 1, wherein M comprises boron, aluminum, gallium, indium, thallium, or a combination comprising at least one of the foregoing, wherein M preferably comprises boron or aluminum.

3. The solar cell of claim 1 or 2, wherein the dielectric layer has a thickness of about 1 nanometer to about 100 nanometers.

4. The solar cell of any one of claims 1 to 3, further comprising a protective layer (132) disposed on a surface of the dielectric layer, wherein the protective layer has a refractive index which is lower than a refractive index of the dielectric layer.

5. The solar cell of claim 4, wherein the protective layer comprises silicon nitride, silicon oxide, aluminum oxide, or a combination comprising at least one of the foregoing.

6. The solar cell of claim 4 or 5, wherein the protective layer has a thickness of about 100 nanometers to about 700 nanometers.

7. The solar cell of any one of claims 1 to 6, wherein the semiconductor substrate further comprises a first side and an opposite second side, the dielectric layer is disposed on the first side of semiconductor substrate, and
the solar cell further comprises an anti-reflection coating (112) disposed on the second side of the semiconductor substrate.

8. The solar cell of claim 7, wherein the n-type layer is adjacent to the first side of the semiconductor substrate and the p-type layer is adjacent to the second side of the semiconductor substrate, or wherein the p-type layer is adjacent to the first side of the semiconductor substrate and the n-type layer is adjacent to the second side of the semiconductor substrate.

9. A method of manufacturing a solar cell, the method comprising:
disposing a semiconductor substrate including a p-type layer and an n-type layer;
disposing a dielectric layer including a silicate represented by the following Chemical Formula 1 on a side of the semiconductor substrate:
Chemical Formula 1 x M₂O₃ · y SiO₂
wherein M is a Group 13 element and x and y are real numbers wherein 0<2x<y and x+y=1;
disposing a first electrode in electrical communication with the p-type layer of the semiconductor substrate; and
disposing a second electrode in electrical communication with the n-type layer of the semiconductor substrate to form the solar cell.

10. The method of claim 9, wherein M comprises boron, aluminum, gallium, indium, thallium, or a combination comprising at least one of the foregoing, wherein M preferably comprises boron or aluminum.

11. The method of claim 9 or 10, wherein the disposing of the dielectric layer comprises disposing a silicon source, an M source, and an oxygen-containing gas.

12. The method of claim 11, wherein the silicon source comprises a compound including silicon, the compound including silicon having a moiety covalently bonded to the silicon, the moiety being hydrogen, a substituted or unsubstituted C1 to C30 alkyl group, a substituted or unsubstituted C3 to C30 cycloalkyl group, a substituted or unsubstituted C6 to C30 aromatic group, a substituted or unsubstituted C1 to C30 alkoxy group, a substituted or unsubstituted amide group, or a combination comprising at least one of the foregoing, wherein the silicon source preferably comprises tetraethoxysilane.

13. The method of claim 11 or 12, wherein the M source comprises a compound including a Group 13 element, the compound including the Group 13 element having a moiety covalently bonded to the Group 13 element, the moiety being hydrogen, a substituted or unsubstituted C1 to C30 alkyl group, a substituted or unsubstituted C3 to C30 cycloalkyl group, a substituted or unsubstituted C6 to C30 aromatic group, a substituted or unsubstituted C1 to C30 alkoxy group, a substituted or unsubstituted amide group, or a combination comprising at least one of the foregoing, wherein the Group 13 element preferably is boron or aluminum and/or wherein the M source preferably comprises trimethylaluminum, trimethylboron, or a combination comprising at least one of the foregoing.

14. The method of any one of claims 11 to 13, wherein the oxygen-containing gas comprises oxygen, ozone, or a combination comprising at least one of the foregoing.

15. The method of any one of claims 9 to 14, wherein the disposing of the dielectric layer comprises atomic layer deposition or plasma enhanced chemical vapor deposition.
